# FASCICULE DE BREVET EUROPEEN

(11) **EP 1 520 294 B1**
(45) Date de publication et mention de la délivrance du brevet: **02.01.2008**
(21) Numéro de dépôt: 03762728.8
(22) Date de dépôt: 02.07.2003
(51) Int. Cl.: H01L 21/331

(54) **DISPOSITIF ELECTRONIQUE, NOTAMMENT DISPOSITIF DE PUISSANCE, A COUCHE MINCE, ET PROCEDE DE FABRICATION DE CE DISPOSITIF**
DÜNNSCHICHT HALBLEITERANORDNUNG, BESONDERS LEISTUNGSANORDNUNG, UND VERFAHREN ZU DEREN HERSTELLUNG
THIN-FILM ELECTRONIC DEVICE, IN PARTICULAR POWER DEVICE, AND METHOD FOR MAKING SAME

(30) Priorité: 05.07.2002 FR 0208453
(43) Date de publication de la demande: 06.04.2005
(73) Titulaire: COMMISSARIAT A L'ENERGIE ATOMIQUE, 75015 Paris (FR)
(72) Inventeur: CLAVELIER, Laurent, F-38400 SAINT MARTIN D'HERES (FR); JALAGUIER, Eric, F-38450 SAINT MARTIN D'URIAGE (FR)
(74) Mandataire: Poulin, Gérard
(86) Numéro de dépôt international: PCT/FR2003/002057
(87) Numéro de publication internationale: WO 2004/006323

(56) Documents cités:
- EP-A- 0 971 418
- EP-A- 1 017 093
- WO-A-01/18853
- US-A- 3 925 808

## Description

### DOMAINE TECHNIQUE

La présente invention concerne un dispositif électronique à couche mince, en particulier un dispositif microélectronique de puissance à couche mince, ainsi qu'un procédé de fabrication de ce dispositif.

Elle s'applique notamment aux dispositifs de commande de moteurs électriques et aux convertisseurs de tension.

Les dispositifs microélectroniques de puissance, ou composants microélectroniques de puissance, sont des structures formées sur des substrats semiconducteurs. Ils sont généralement utilisés comme interrupteurs pour réaliser des organes de conversion d'énergie.

La plupart de ces composants ont une structure verticale : dans un composant de ce genre, le courant circule entre la face avant et la face arrière du substrat sur lequel il est formé.

Un composant de puissance est caractérisé par deux paramètres principaux :
- sa tenue en tension, qui dépend de l'épaisseur et de la résistivité du substrat sur lequel il est formé, et
- son calibre en courant, qui dépend de la surface active du composant, cette surface étant la plus petite possible pour des questions de coût.

On classe les composants de puissance en deux catégories, suivant leur type de conduction :
- la catégorie des composants à conduction unipolaire, où un seul type de porteur participe à la circulation du courant, cette catégorie contenant par exemple les transistors MOS, et
- la catégorie des composants à conduction bipolaire, où les deux types de porteurs participent à la conduction, cette catégorie contenant par exemple les IGBT (transistors bipolaires à grille isolée).

L'un des aspects de l'optimisation d'un composant de puissance consiste à réduire ses pertes, à calibre en tension et densité de courant donnés. On distingue quatre sortes de pertes :
- les pertes dues au passage de l'état non conducteur à l'état conducteur, appelées pertes OFF=>ON, qui sont en majeure partie imposées par des éléments extérieurs au composant considéré (circuit),
- les pertes dues à l'état conducteur, appelées pertes à l'état ON ou pertes statiques ON, dont la diminution (à calibre en courant fixé) nécessite de réduire la chute de tension aux bornes du composant considéré lorsque celui-ci conduit le courant, ce qui revient à réduire sa résistance ON notée Ron (résistance à l'état conducteur),
- les pertes dues au passage de l'état conducteur à l'état non conducteur, appelées pertes ON=>OFF, et
- les pertes dues à l'état non conducteur, appelées pertes à l'état OFF ou pertes statiques OFF, qui sont négligeables par rapport aux autres pertes.

Dans la présente invention, on s'intéresse à la réduction des pertes statiques ON et des pertes de commutation ON=>OFF en particulier dans les composants bipolaires (par exemple IGBT).

Comme on l'a vu, pour diminuer les pertes à l'état ON d'un composant de puissance (à calibre en courant fixé), il faut réduire la chute de tension aux bornes de ce composant lorsque celui-ci conduit le courant. Cela revient à réduire la résistance ON (Ron) de ce composant.

Pour diminuer cette résistance Ron, quatre possibilités existent :
- On peut réduire l'épaisseur du substrat du composant; en effet, on a seulement besoin au plus de 0,1µm d'épaisseur par volt de tenue en tension, c'est à dire de 60µm d'épaisseur pour un composant dont la tenue en tension est 600V.
   Actuellement, la limitation de l'épaisseur se heurte au problème du rendement mécanique : plus la plaque du substrat est fine, plus elle est fragile.
- On peut augmenter la surface active de passage du courant. Ceci se fait au détriment du coût; on cherche plutôt à réduire au maximum la surface de la zone active.
- On peut diminuer la résistivité du substrat; à tenue en tension donnée, il existe un optimum pour la résistivité du substrat.
- On peut augmenter l'injection de porteurs minoritaires dans la zone faiblement dopée du composant. Dans le cas d'un composant IGBT il suffit, pour ce faire, de former une couche P+ fortement dopée sur la face arrière de ce composant. Mais cela se fait au détriment des pertes en commutation ON=>OFF. Il y a donc un compromis à trouver entre les caractéristiques à l'état ON et les caractéristiques de commutation ON=>OFF.

Pour réduire simultanément les pertes à l'état ON et les pertes de commutation ON=>OFF, une voie envisageable est :
de réduire l'épaisseur du substrat au minimum qui est imposé par le critère de tenue en tension, et
- d'optimiser l'injection par la face arrière, en se plaçant au meilleur compromis entre les pertes ON=>OFF et la chute de tension ON.

Ce compromis est dicté par le type d'application dans lequel on souhaite utiliser le composant de puissance. On se place à la limite basse pour l'injection par la face arrière sans que cela ne dégrade les caractéristiques à l'état conducteur, ou caractéristiques ON, du composant. On fait simplement un émetteur moins efficace.

Il convient de noter que la présente invention s'applique aussi à la fabrication de composants unipolaires et de composants bipolaires sur des plaques ultraminces, dont la fabrication nécessite des étapes de traitement (par exemple des lithographies, des gravures, et des implantations) de la face arrière de ces plaques.

### ETAT DE LA TECHNIQUE ANTERIEURE

Il est connu de former un composant de puissance sur un substrat massif (en anglais "bulk") "standard". Ce dernier est initialement homogène : le dopage est identique en tout point de ce substrat.

L'épaisseur du substrat n'est pas optimisée pour la tenue en tension visée. Par exemple, pour un composant du type 600V, du point de vue électrique il suffirait d'un substrat ayant une épaisseur de 60µm au lieu des épaisseurs supérieures à 200µm habituellement utilisées.

Les pertes à l'état ON peuvent être réduites en formant un émetteur de forte efficacité, au détriment de la réduction des pertes ON=>OFF, ou vice-versa.

L'utilisation de substrats massifs "standard" oblige ainsi à trouver un compromis entre réduction des pertes ON et réduction des pertes ON=>OFF.

Il est également connu d'amincir un substrat à la fin du procédé de fabrication d'un composant de puissance sur ce substrat. On obtient ainsi un composant sur une plaque ultra-mince.

On met en oeuvre le début du procédé sur une plaque standard, dont l'épaisseur est supérieure à 300µm, puis on amincit cette plaque par la face arrière jusqu'à l'obtention de l'épaisseur voulue, par exemple jusqu'à 701µm pour des substrats de 150mm de diamètre. Ensuite, on accomplit les étapes de face arrière en prenant soin de réduire leur nombre au minimum.

En optimisant les dopages de la face arrière et les recuits, on peut obtenir un émetteur dont l'efficacité est suffisamment élevée pour ne pas dégrader Ron et suffisamment faible pour réduire les pertes de commutation ON=>OFF.

A ce sujet, on pourra consulter les documents suivants :
T. LASKA, M. MATSCHITSCH et W. SCHOLZ, "Ultra-thin wafers technology for a new 600V-NPT-IGBT", ISPSD'1997, 1997, pages 361 à 364
T. LASKA, M. MUNZER, F. PFIRSCH, C. SCHAEFFER et T. SCHMIDT, "The Field Stop IGBT (FS IGBT), a new power device concept with a great improvement potential", ISPSD'2000, mai 2000, pages 355 à 358.

Cette technique des plaques amincies en fin de procédé permet d'obtenir des plaques minces avec un émetteur de faible efficacité, dont la couche P+ est obtenue avec une faible dose implantée et une faible diffusion, ce qui réduit simultanément les pertes statiques ON et les pertes dynamiques ON=>OFF.

Cependant, l'utilisation de cette technique est limitée par la solidité des plaques : plus les plaques sont minces et plus le rendement mécanique diminue.

Ainsi les utilisateurs de cette technique sont-ils actuellement limités à une épaisseur de 70µm pour des plaquettes (en anglais "wafers") de 6 pouces (environ 15cm) de diamètre. Ils ne peuvent pas passer à des plaquettes de 8 pouces (environ 20cm) tout en conservant cette épaisseur de 70µm.

En outre, pour réduire "l'épaisseur électrique" (c'est à dire l'épaisseur électriquement active) d'un composant de puissance, il est connu de former ce composant sur un substrat épitaxié.

Il s'agit d'une couche fortement résistive de faible épaisseur, déposée sur un substrat semiconducteur fortement dopé, le composant de puissance étant formé sur la face de forte résistivité du substrat.

Cette technique permet de réduire la chute de tension lors du passage du courant, et donc les pertes à l'état ON, car la couche résistive est de faible épaisseur (cette dernière étant optimisée pour la tenue en tension visée).

Mais cette technique ne permet pas de réduire les pertes en commutation ON=>OFF car l'émetteur de face arrière est composé d'une "semelle" P+ de forte épaisseur et fort dopage. Ceci entraîne une forte injection de porteurs minoritaires dans la zone faiblement dopée et conduit à de longs temps de commutation ON=>OFF et donc à de fortes pertes.

Pour réduire cette injection en face arrière, une zone N peut être insérée juste au dessus de la zone P+, lors de la fabrication du substrat. On obtient alors une jonction P+/N qui injecte moins de porteurs minoritaires dans la zone N- que si l'on avait une jonction P+/N-.

Notons que cette technique est parfois utilisée lors de la fabrication de composants sur des plaques standard ou sur des plaques minces.

La technique qui utilise des substrats epi permet donc de réduire les pertes ON mais entraîne des pertes ON=>OFF relativement élevées.

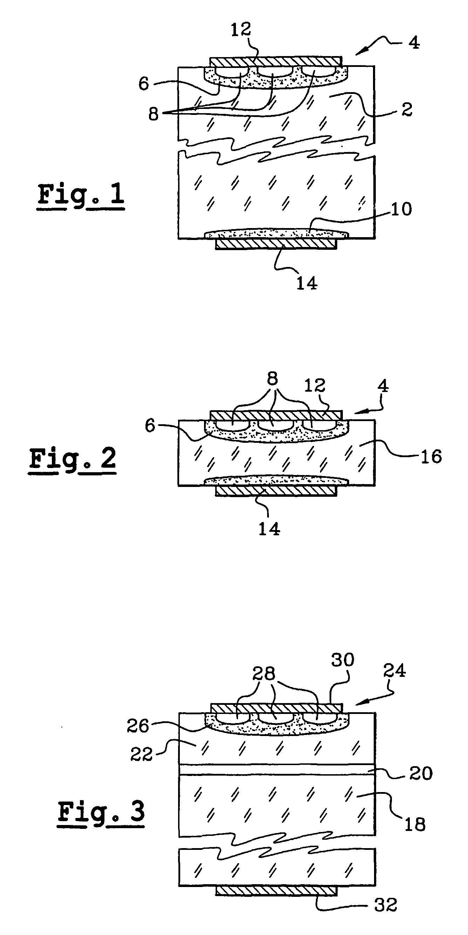

L'art antérieur que l'on a exposé est très schématiquement illustré par les figures 1 à 3.

La technique utilisant un substrat semiconducteur massif « standard » est très schématiquement illustrée par la figure 1 où l'on voit ce substrat 2 dans lequel est formé un composant 4 de puissance à structure verticale. Ce composant comporte des zones qui sont implantées dans le substrat.

Par exemple, en supposant que le substrat 2 est de type N, une zone 6 de type P est implantée du côté de la face avant de ce substrat, plusieurs zones 8 de type N+ sont implantées dans cette zone 6 et une autre zone 10 de type P, de faible épaisseur, est implantée du côté de la face arrière du substrat.

Sur la figure 1, la référence 12 symbolise des contacts électriques associés aux zones 6 et 8 et la référence 14 symbolise un contact électrique associé à la zone 10.

La technique utilisant un substrat semiconducteur que l'on amincit à la fin du procédé de fabrication du composant de puissance est très schématiquement illustrée par la figure 2 où l'on voit ce substrat 16 ainsi que ce composant 4, dont la structure est identique à celle qui a été décrite plus haut, en faisant référence à la figure 1, mais qui est formé dans ce substrat 16.

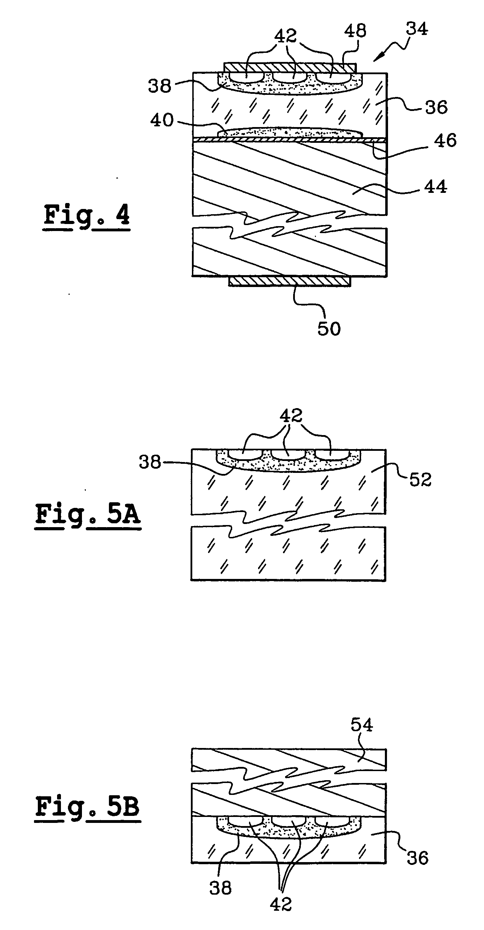

La technique utilisant un substrat semiconducteur épitaxié est très schématiquement illustrée par la figure 3 où l'on voit un substrat semiconducteur 18 par exemple de type P+, ayant une très faible résistivité et comportant une zone 20 de type N sur sa face avant.

Sur cette zone 20 est épitaxiée une zone semiconductrice 22 de faible épaisseur, de type N-. Le composant 24 de puissance, qui est formé sur le substrat epi, comprend, dans cette zone 22, du côté de la face avant de cette dernière, une zone implantée 26 de type P et plusieurs zones 28 de type N+ qui sont implantées dans cette zone 26.

Sur la figure 3, la référence 30 symbolise des contacts électriques associés aux zones 26 et 28 et la référence 32 symbolise un contact électrique qui est formé sur la face arrière du substrat 18.

### EXPOSÉ DE L'INVENTION

La présente invention a pour but de remédier aux inconvénients mentionnés plus haut à propos de ces trois techniques connues.

Elle a tout d'abord pour objet un dispositif électronique comprenant une partie active, une première couche mince qui est faite d'un matériau semiconducteur et dans laquelle est formée cette partie active, et un substrat qui est fait d'un matériau électriquement conducteur, ce dispositif étant caractérisé en ce qu'il comprend en outre une zone de recombinaison des porteurs, qui est située entre le substrat et la première couche mince et qui assure également un contact électrique ohmique entre ce substrat et cette première couche mince.

Selon un mode de réalisation préféré du dispositif objet de l'invention, la zone de recombinaison des porteurs est une deuxième couche mince qui est faite d'un matériau électriquement conducteur et qui assure un collage électriquement conducteur entre le substrat et la première couche mince.

Selon un mode de réalisation particulier du dispositif objet de l'invention, les deux faces de la première couche mince sont traitées pour former des zones actives du dispositif.

Le matériau dont est faite la zone de recombinaison des porteurs peut être un métal.

En variante, le matériau dont est faite la zone de recombinaison des porteurs est un alliage semiconducteur/métal.

Cet alliage dont est faite la zone de recombinaison des porteurs est de préférence choisi de façon qu'il soit stable vis-à-vis des matériaux dont sont respectivement faits le substrat et la première couche mince.

Le matériau dont est fait le substrat peut être un semiconducteur fortement dopé, en particulier le silicium fortement dopé.

Dans ce cas le matériau dont est faite la zone de recombinaison des porteurs peut être un métal, ce métal étant choisi de façon qu'il forme, lors de la réalisation du contact électrique ohmique, un alliage stable avec le semiconducteur fortement dopé dont est fait le substrat et avec le matériau semiconducteur dont est faite la première couche mince.

En variante, le matériau dont est fait le substrat est un métal.

Dans ce cas, la zone de recombinaison des porteurs peut être faite du métal dont est fait le substrat et formée par une partie de ce substrat.

La présente invention concerne aussi un procédé de fabrication d'un dispositif électronique, ce procédé étant caractérisé en ce qu'il comprend les étapes suivantes :
- on forme une partie du dispositif dans un substrat semiconducteur standard, du côté de la face avant de ce substrat semiconducteur standard,
- on fixe un support de traitement à la face avant du substrat,
- on amincit le substrat semiconducteur standard par la face arrière de celui-ci, de manière à le transformer en une couche mince,
- on forme une autre partie du dispositif dans le substrat semiconducteur standard ainsi transformé, du côté de la face arrière de ce substrat semiconducteur standard,
- on dépose, sur la face arrière de ce substrat semiconducteur standard et/ou sur une face d'un substrat électriquement conducteur, une couche mince, formée d'un métal ou d'un alliage métal/semiconducteur,
- on procède, par l'intermédiaire de la couche mince, formée du métal ou de l'alliage métal/semiconducteur, à un collage électriquement conducteur entre le substrat électriquement conducteur et la couche mince en laquelle a été transformé le substrat semiconducteur standard, et
- on enlève le support de traitement.

La présente invention concerne en outre un procédé de fabrication d'un dispositif électronique, ce procédé étant caractérisé en ce qu'il comprend les étapes suivantes :
- on forme une partie du dispositif dans un substrat semiconducteur standard, du côté de la face arrière de ce substrat semiconducteur standard,
- on dépose, sur la face arrière de ce substrat semiconducteur standard et/ou sur une face d'un substrat électriquement conducteur, une couche mince, formée d'un métal ou d'un alliage métal/semiconducteur,
- on procède à un collage électriquement conducteur entre le substrat électriquement conducteur et le substrat semiconducteur standard, par l'intermédiaire de la couche mince,
- on amincit le substrat semiconducteur standard par la face avant de celui-ci, de manière à le transformer en une couche mince, et
- on forme une autre partie du dispositif dans le substrat semiconducteur standard ainsi transformé, du côté de la face avant de ce substrat semiconducteur standard.

On peut former en outre des contacts électriques du dispositif sur la couche mince, en laquelle a été transformé le substrat semiconducteur standard, et sur le substrat électriquement conducteur.

Le substrat électriquement conducteur peut être fait d'un matériau choisi parmi les semiconducteurs fortement dopés, en particulier le silicium fortement dopé, et les conducteurs,en particulier les métaux.

En particulier, le substrat électriquement conducteur peut être fait d'un matériau choisi parmi les semiconducteurs fortement dopés, en particulier le silicium fortement dopé, le métal ou l'alliage métal/semiconducteur étant choisi de sorte qu'il forme, après un recuit suivant le collage électriquement conducteur, un alliage stable avec le matériau dont est fait le substrat électriquement conducteur et avec le matériau dont est fait le substrat semiconducteur standard.

De préférence, l'étape de collage électriquement conducteur est précédée d'une étape de préparation d'au moins l'une des deux faces à assembler par le collage électriquement conducteur afin de favoriser ce collage.

De préférence également, le collage électriquement conducteur est choisi parmi le collage par brasure, le collage par thermocompression et le collage par adhésion moléculaire.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés, sur lesquels:
- les figures 1 à 3 illustrent très schématiquement des techniques connues pour fabriquer des dispositifs de puissance respectivement sur un substrat massif standard (figure 1), sur un substrat aminci en fin de procédé (figure 2) et sur un substrat épitaxié (figure 3) et ont déjà été décrites,
- la figure 4 est une vue en coupe schématique d'un mode de réalisation particulier du dispositif objet de l'invention, et
- les figures SA à 5D illustrent schématiquement diverses étapes d'un mode de mise en oeuvre particulier du procédé objet de l'invention.

### EXPOSÉ DÉTAILLÉ DE MODES DE RÉALISATION PARTICULIERS

Selon un procédé conforme à l'invention, on forme un composant électronique, plus particulièrement un composant de puissance, dans une couche mince de matériau semiconducteur. On limite ainsi l'épaisseur du composant à celle d'une couche mince (épaisseur inférieure ou égale à 200µm, typiquement de l'ordre de 50µm ou moins).

On reporte ensuite cette couche, par un collage électriquement conducteur, sur un substrat dont la fonction est double : ce substrat assure la tenue mécanique de l'ensemble et la reprise de contact en la face arrière du composant, sans intervenir dans le fonctionnement de ce dernier.

On propose ainsi un procédé de fabrication de composants de puissance dont l'épaisseur électrique est faible, typiquement de 50 µm, avec traitement double face, et dont l'épaisseur mécanique est standard, typiquement de l'ordre de 500µm pour un substrat processé de 100mm de diamètre.

Ce procédé permet de réduire simultanément les pertes à l'état ON et les pertes de commutation ON=>OFF (on obtient les mêmes pertes ON et ON=>OFF que pour un composant formé sur plaque ultra-mince, conformément à une technique connue, mentionnée plus haut) tout en ayant un substrat dont la tenue mécanique est celle d'un substrat "standard" (on obtient la même rigidité mécanique que dans le cas des plaques standard ou épitaxiées mentionnées plus haut).

Le procédé proposé ne conduit pas à des limitations de dimensions, tant pour les épaisseurs respectives de la plaque mince, ou couche mince, et de la plaque de support, ou substrat de support, que pour les diamètres respectifs de ces plaques (qui ont généralement le même diamètre).

La figure 4 est une vue en coupe schématique d'un mode de réalisation particulier du dispositif objet de l'invention. Il s'agit par exemple d'un écrêteur de tension 34 qui est formé sur une plaque semiconductrice mince 36.

Des zones 38 et 40 sont respectivement implantées sur la face avant et sur la face arrière de cette plaque 36. On voit en outre des zones 42 qui sont implantées dans la zone 38. Cette zone 38 et la zone 40 sont des zones actives du dispositif.

L'écrêteur de tension 34 comprend en outre une plaque de support 44 qui est très faiblement résistive et dont la face avant est en contact électrique, ou contact ohmique, avec la face arrière de la plaque mince 36 par l'intermédiaire d'un collage métallique 46.

En outre, des contacts électriques 48 et 50 sont formés sur la face avant de la plaque mince 36 et sur la face arrière de la plaque de support 44.

La plaque mince 36 est donc la plaque électriquement active sur laquelle est formé un composant de puissance 34 (écrêteur de tension) dont l'épaisseur électrique (typiquement 50µm ou moins), correspondant à l'épaisseur de la plaque mince 36, est faible.

A la différence, des composants réalisés sur des plaques épitaxiées, cette plaque comporte des zones traitées (par exemple par lithographie ou par gravure) sur ses deux faces (alors qu'une plaque épitaxiée ne comporte qu'une seule face traitée, à savoir la face avant).

L'émetteur (zone 40, par exemple de type P+) que comporte le composant a une faible efficacité qui résulte d'une faible dose implantée et d'une faible diffusion (mais on pourrait aussi insérer une zone N avant de réaliser la zone P+ pour réduire l'efficacité de l'émetteur).

Cet émetteur peut être formé sur la face arrière de la plaque 36 à la fin du traitement de cette plaque, avant de coller cette dernière sur la plaque de support 44.

Cette plaque de support (qui est par exemple une plaque de Si très faiblement résistif) ne joue aucun rôle actif dans le fonctionnement du composant. Elle assure simplement l'amenée du courant du contact 50, ou contact de face arrière, vers la face arrière de la plaque mince 36 et doit être aussi conductrice que possible afin de réduire au maximum les pertes à l'état ON.

Cette plaque 44 n'est pas forcément en silicium. Elle peut être faite d'un autre semiconducteur, d'un métal ou de tout autre matériau conducteur (un polymère conducteur par exemple).

Cette plaque de support 44 assure, comme on l'a vu, la rigidité mécanique de l'ensemble.

Le collage métallique 46 assure le contact électrique ohmique entre les deux plaques 36 et 44. La valeur de la résistance de ce contact doit être la plus faible possible pour réduire les pertes à l'état ON.

Pour obtenir un collage ohmique répondant à ces exigences, il est nécessaire que les concentrations surfaciques des dopants soient suffisamment élevées (sur la face arrière de la plaque active (plaque 36) et sur la face avant de la plaque de support 44 si celle-ci est faite d'un matériau semiconducteur).

La concentration minimale dépend du type de métal choisi pour le collage métallique. Si le dopage surfacique n'est pas suffisant, on peut obtenir une diode Schottky en série avec le composant réalisé, ce qui n'est pas le but recherché.

Ce collage métallique est une zone de recombinaison de tous les porteurs. Par exemple, dans le cas où la plaque de support 44 est une plaque P+ fortement dopée et où l'émetteur est une couche P+, la couche métallique permet de ne pas se trouver dans le cas des plaques épitaxiées, en constituant une zone de recombinaison des porteurs qui se comporte comme une zone de rupture des phénomènes de la physique des semiconducteurs entre les deux plaques 36 et 44.

On a donc un composant de puissance qui est formé sur une plaque mince et comporte un émetteur de faible efficacité (et/ou est formé par un procédé comportant des étapes technologiques sur la face arrière, telles que, par exemple, des lithographies sur cette face arrière ainsi qu'un alignement utilisant la face avant).

De plus, la rigidité mécanique de ce composant de puissance est celle d'un composant réalisé sur une plaque épaisse.

On obtient ainsi de faibles pertes ON, de faibles pertes de commutation ON=>OFF et des rendements mécaniques comparables à ceux que l'on obtient lors de la réalisation de composants sur des plaques "standard".

On décrit ci-après un exemple de fabrication d'un composant de puissance vertical sur une plaque électriquement ultra-mince et mécaniquement épaisse, conformément à l'invention.

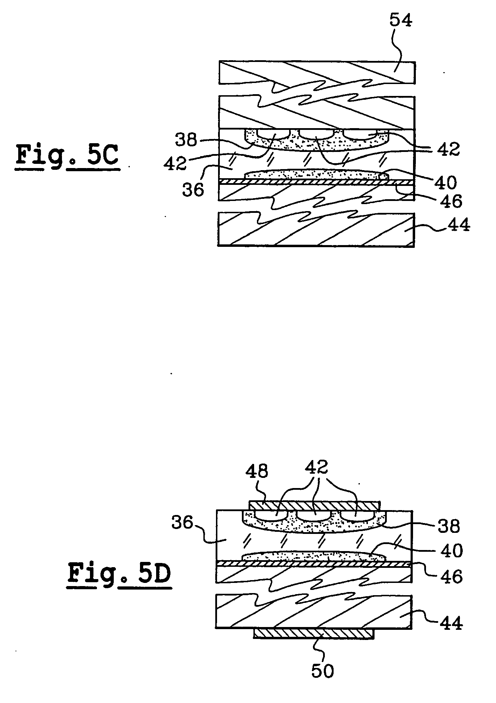

Tout au long de ce processus technologique on remarquera qu'aucune plaque mince n'est manipulée directement et que l'on utilise toujours des poignées (support de face avant 54 sur la figure 5B) pour conserver une épaisseur "standard", ce qui garantit une bonne rigidité et permet l'utilisation d'équipements et de processus "standard" de la microélectronique.
1. On part d'une plaque active 52 (figure 5A) qui a une épaisseur standard (forte d'épaisseur) et sur laquelle on effectue les étapes technologiques de la face avant : on forme les zones implantées 38 et 42 déjà mentionnées dans la description de la figure 4.
2. Après avoir éventuellement reporté des marques d'alignement sur la face arrière de la plaque active 52, une plaque de support 54, qui sert de poignée, est collée contre la face avant de la plaque active 52 (figure 5B).
   Les marques d'alignement peuvent être, par exemple, des motifs spécifiques d'alignement (croix ou mires) ou des réseaux de diffraction permettant d'aligner les niveaux de masques les uns par rapport aux autres.
   Les marques d'alignement, sont éventuellement reportées sur la face avant de la plaque de support 54.
   La face arrière de la plaque active 52 est ensuite amincie jusqu'à l'épaisseur voulue (par exemple 60µm pour une tenue en tension de 600V). On obtient ainsi la plaque active mince 36 de la figure 4 à partir de la plaque épaisse 52.
   Il convient de noter que l'épaisseur totale de la plaque 36 et du support 54 est forte.
3. Les étapes de traitement de la face arrière de la plaque active mince 36 sont réalisées (formation de la zone 40).
   Si des alignements sont nécessaires, ils peuvent être faits car les marques d'alignement existent sur la face avant du support 54.
   Le support conducteur 44 (plaque de support très faiblement résistive) est collé sur la face arrière de la plaque mince 36 par l'intermédiaire de l'interface métallique 46 (figure 5C).
4. La plaque de support 54 est ensuite retirée (par décollement, élimination ou une autre méthode), on achève le traitement de la face arrière de la plaque active 36 et les contacts de face avant et de la face arrière 48 et 50 sont formés.

Dans une variante du procédé que l'on vient d'exposer, on peut d'abord traiter la face arrière de la plaque épaisse 52, coller cette face arrière au support conducteur 44 par l'intermédiaire du collage métallique 46, amincir la plaque épaisse 52 par sa face avant et traiter la face avant de la plaque mince obtenue 36 pour y former les zones 38 et 42. Dans ce cas, on n'a pas besoin de poignée-support.

Cependant, dans ce cas, le traitement de la face arrière de la plaque épaisse 52 nécessite un chauffage par bilan thermique plus important que pour la face avant, ce qui limite les possibilités pour la face arrière (notamment en matière de profils de dopants et collage conducteur).

On a formé des composants sur des substrats minces, de 100µm d'épaisseur, en utilisant le processus précédent. On a par exemple formé un écrêteur de tension ou micro-parafoudre :
1. Des zones P et N+ ont été formées sur la face avant d'une plaque de silicium de 4 pouces (environ 10cm) de diamètre et de 550µm d'épaisseur, constituant une plaque active.
2. Après dépôt d'une épaisse couche d'oxyde de silicium sur la face avant de cette plaque et planarisation de cette couche, on a collé une poignée de support sur la face avant, cette poignée ayant une épaisseur de 550µm.
   La plaque active a été amincie par sa face arrière jusqu'à une épaisseur de 100µm. A ce stade, l'ensemble formé par la poignée et la plaque active avait une épaisseur de 650µm.
3. Le traitement de la face arrière de la plaque active a été réalisé (photo-lithographie, gravures, implantation P+, recuits à des températures supérieures à 1000°C).
   Un dépôt de palladium de quelques dizaines de nanomètres d'épaisseur a été formé sur la face arrière de la plaque active et un autre dépôt de la même épaisseur a été formé sur une plaque de support en silicium dopé N+, de quelques mohms.cm de résistivité et de 550µm d'épaisseur.
   Après nettoyage des surfaces et mise en contact des surfaces à coller, un recuit approprié a été effectué. A ce stade, la plaque traitée avait une épaisseur de 1200µm.
4. La plaque supérieure constituant la poignée a été éliminée, les ouvertures des contacts électriques ont été formées puis les métallisations de la face avant et de la face arrière ont été formées (dépôt, photolithographie, gravure et recuit du métal).

A la fin de ce processus la plaque a une épaisseur de 650µm.

Des mesures de caractéristiques dynamiques ont été faites sur les composants ainsi fabriqués et montrent l'avantage résultant de la formation de tels composants sur des plaques ultra-minces traitées sur leurs deux faces.

En effet, l'écrêtage en tension est beaucoup plus franc et les fronts de commutation sont plus importants que pour les composants formés de façon classique, tout en diminuant les pertes statiques par rapport aux composants formés sur des plaques standard.

On connaît différentes techniques de scellement métallique pour coller deux plaques en matériaux semiconducteurs.

On peut utiliser un brasage, méthode de soudure qui consiste à assembler deux matériaux par la refusion d'un métal non ferreux.

On utilise les scellements par brasage au moyen de couches relativement épaisses, appelées "préformes", d'environ 50µm d'épaisseur. Dans ce cas, les alliages fusibles utilisés sont de type SnPb (dont la température de fusion Tf vaut 180°C), AuSn (Tf=280°C) ou AuSi (Tf=460°C).

On utilise aussi les scellements par brasage à l'aide de couches minces dont l'épaisseur vaut quelques micromètres. Les métaux fusibles utilisés peuvent être de type AuSn (80/20), SnPb ou Ni.

On peut aussi utiliser un scellement par thermocompression avec des couches métalliques, par exemple des couches de Ti ou de Ta.

Ces techniques sont plutôt utilisées pour l'hybridation de composants de petites dimensions. Leur application au collage de surfaces de grandes dimensions (cas de plaques en matériaux semiconducteurs) est néanmoins délicate.

En effet, ces techniques de scellement utilisent des couches métalliques relativement épaisses, de plusieurs micromètres, voire de plusieurs dizaines de micromètres, d'épaisseur.

En conséquence, on n'est pas sûr de la tenue mécanique de ces couches métalliques ni de celle de l'ensemble collé plaque de semi-conducteur/alliage métallique/plaque de semiconducteur, lors de traitements thermiques, en particulier lors de refroidissements, en raison de la forte différence entre les coefficients de dilatation thermique des métaux et ceux des semiconducteurs.

C'est pourquoi on utilise de préférence les techniques de collage par adhésion moléculaire.

Le collage par adhésion moléculaire, ou collage direct (en anglais "wafer bonding"), est un procédé par lequel deux surfaces adhèrent l'une à l'autre à température ambiante, sans l'intervention d'une colle ou de forces externes.

Un tel collage a lieu lorsque les deux surfaces à sceller sont suffisamment lisses et propres et placées à faible distance, de l'ordre de 10 à 100 nanomètres, l'une de l'autre. Les forces attractives entre les deux surfaces deviennent alors assez grandes pour les attirer l'une vers l'autre. Après une initiation en un point de contact, une propagation spontanée de l'adhésion a lieu.

Cette technique se différencie des autres méthodes de scellement par le fait qu'elle permet le collage de grandes surfaces de plaques semiconductrices à température ambiante. La réussite d'un tel collage, en termes de défauts de collage et de forces d'adhésion, est essentiellement fondée sur le savoir-faire et la maîtrise des nettoyages des surfaces qui vont être mises en contact.

Le collage par adhésion moléculaire peut être utilisé pour connecter électriquement deux plaques semiconductrices. Dans ce cas, typiquement, une fine couche d'un métal approprié, dont l'épaisseur est inférieure à 1µm, recouvre l'une des deux surfaces à coller ou ces deux surfaces.

Le collage métallique, par adhésion moléculaire, est étudié par de nombreuses équipes de recherche, dont les divers travaux ont permis de tester la capacité à coller de diverses couches métalliques essentiellement déposées sur du silicium.

Selon un procédé conforme à l'invention, on reporte un film mince de quelques dizaines de micromètres, partiellement traité sur ses deux faces, sur un support conducteur, par l'intermédiaire d'un collage permettant une bonne continuité électrique entre les éléments mis en contact.

Après ce collage conducteur, la structure ainsi obtenue est soumise aux dernières étapes technologiques de fabrication (par exemple des métallisations) du dispositif.

On choisit donc la mise en oeuvre d'un collage métallique par adhésion moléculaire qui est compatible avec les étapes technologiques de fabrication du dispositif considéré, ces étapes étant réalisées avant et après le collage métallique.

On s'attachera en particulier à vérifier que les traitements thermiques mis en oeuvre lors du procédé de collage métallique sont compatibles avec la technologie du dispositif considéré.

Dans l'exemple de réalisation d'une structure telle qu'un film ou une plaque mince de silicium que l'on rend solidaire d'un support en silicium par l'intermédiaire d'un collage conducteur, on choisira préférentiellement des métaux ou des composés métalliques, capables de former des alliages stables avec le silicium, lors de la formation du collage métallique.

Le tableau I, qui se trouve à la fin de la présente description, est extrait du document suivant :
M.A. Nicolet et S.S. Lau, "Silicides", VLSI Handbook, Academic Press, Chapitre 24, pages 415 à 433, 1985.

Il donne quelques exemples de métaux pouvant être utilisés pour le collage conducteur, par adhésion moléculaire, de plaques de silicium entre elles, ainsi que les alliages (siliciures) formés entre ces métaux et le silicium et, pour chaque siliciure, la température de formation de ce siliciure et la valeur de résistivité.

Diverses variantes pour le collage conducteur, par adhésion moléculaire, d'une plaque mince de silicium peuvent être utilisées :
On peut déposer l'élément A (voir le tableau I) sur la face arrière de la plaque mince et/ou sur la face avant du support conducteur.

Au lieu de cela, on peut déposer le siliciure A-Si est déposé sur la face arrière de la plaque mince et/ou sur la face avant du support conducteur.

**TABLEAU 1**

| Elément (A) | Siliciure (A-Si) | Température de formation (°C) | Résistivité (10⁻⁶ohm.cm) |
|---|---|---|---|
| Ti | TiSi | 500 | 63+6 |
| | TiSi₂ | 600 | 10-25 |
| V | VSi₂ | 600 | 50-55 |
| Cr | CrSi₂ | 450 | >250-1420 |
| Mn | MnSi | 400-500 | 200-260 |
| | MnSi₂ | 800 | 6500-13000 |
| Fe | FeSi | 450-550 | 260-290 |
| | FeSi₂ | 550 | - |
| Co | Co₂Si | 350-500 | 60-130 |
| | CoSi | 375-500 | 90-170 |
| | CoSi₂ | 550 | 18-65 |
| Ni | Ni₂Si | 200-350 | 20-25 |
| | NiSi | 350-750 | 14-50 |
| | NiSi₂ | ≥750 | 34-60 |
| Mo | MoSi₂ | 525 | 21-200 |
| Pd | Pd₂Si | 100-300 | 25-35 |
| | PdSi | 850 | - |
| Ta | TaSi₂ | 650 | 8.5-55 |
| W | WSi₂ | 650 | 50-200 |
| Pt | Pt₂Si | 200-500 | - |
| | PtSi | 300 | 28-40 |

## Revendications

1. Dispositif électronique comprenant une partie active (38, 40, 42), une première couche mince (36) qui est faite d'un matériau semiconducteur et dans laquelle est formée cette partie active, et un substrat (44) qui est fait d'un matériau électriquement conducteur, ce dispositif étant **caractérisé en ce qu'**il comprend en outre une zone de recombinaison des porteurs (46), qui est située entre le substrat et la première couche mince et qui assure également un contact électrique ohmique entre ce substrat et cette première couche mince.

2. Dispositif selon la revendication 1, dans lequel la zone de recombinaison des porteurs est une deuxième couche mince (46) qui est faite d'un matériau électriquement conducteur et qui, assure un collage électriquement conducteur entre le substrat et la première couche mince.

3. Dispositif selon l'une quelconque des revendications 1 et 2, dans lequel les deux faces de la première couche mince (36) sont traitées pour former des zones actives (38, 40) du dispositif.

4. Dispositif selon l'une quelconque des revendications 1 à 3, dans lequel le matériau dont est faite la zone de recombinaison des porteurs (46) est un métal.

5. Dispositif selon l'une quelconque des revendications 1 à 3, dans lequel le matériau dont est faite la zone de recombinaison des porteurs (46) est un alliage semiconducteur/métal.

6. Dispositif selon la revendication 5, dans lequel l'alliage dont est faite la zone de recombinaison des porteurs (46) est choisi de façon qu'il soit stable vis-à-vis des matériaux dont sont respectivement faits le substrat et la première couche mince.

7. Dispositif selon l'une quelconque des revendications 1 à 6, dans lequel le matériau dont est fait le substrat (44) est un semiconducteur fortement dopé.

8. Dispositif selon la revendication 7, dans lequel le semiconducteur fortement dopé est le silicium.

9. Dispositif selon l'une quelconque des revendications 7 et 8 dans lequel le matériau dont est faite la zone de recombinaison des porteurs (46) est un métal et ce métal est choisi de façon qu'il forme, lors de la réalisation du contact électrique ohmique, un alliage stable avec le semiconducteur fortement dopé dont est fait le substrat et avec le matériau semiconducteur dont est faite la première couche mince.

10. Dispositif selon l'une quelconque des revendications 1 à 6, dans lequel le matériau dont est fait le substrat (44) est un métal.

11. Dispositif selon la revendication 10, dans lequel la zone de recombinaison des porteurs (46) est faite du métal dont est fait le substrat et formée par une partie de ce substrat.

12. Procédé de fabrication d'un dispositif électronique, ce procédé étant **caractérisé en ce qu'**il comprend les étapes suivantes :
- on forme une partie (38, 42) du dispositif dans un substrat semiconducteur standard (52), du côté de la face avant de ce substrat semiconducteur standard,
- on fixe un support de traitement (54) à la face avant du substrat,
- on amincit le substrat semiconducteur standard par la face arrière de celui-ci, de manière à le transformer en une couche mince (36),
- on forme une autre partie (40) du dispositif dans le substrat semiconducteur standard ainsi transformé, du côté de la face arrière de ce substrat semiconducteur standard,
- on dépose, sur la face arrière de ce substrat semiconducteur standard et/ou sur une face d'un substrat électriquement conducteur, une couche mince, formée d'un métal ou d'un alliage métal/semiconducteur,
- on procède, par l'intermédiaire de la couche mince, formée du métal ou de l'alliage métal/semiconducteur, à un collage électriquement conducteur entre le substrat électriquement conducteur et la couche mince en laquelle a été transformé le substrat semiconducteur standard, et
- on enlève le support de traitement (54).

13. Procédé de fabrication d'un dispositif électronique, ce procédé étant **caractérisé en ce qu'**il comprend les étapes suivantes :
- on forme une partie (38, 42) du dispositif dans un substrat semiconducteur standard (52), du côté de la face arrière de ce substrat semiconducteur standard,
- on dépose, sur la face arrière de ce substrat semiconducteur standard et/ou sur une face d'un substrat électriquement conducteur, une couche mince, formée d'un métal ou d'un alliage métal/semiconducteur,
- on procède à un collage électriquement conducteur entre le substrat électriquement conducteur et le substrat semiconducteur standard, par l'intermédiaire de la couche mince,
- on amincit le substrat semiconducteur standard par la face avant de celui-ci, de manière à le transformer en une couche mince (36), et
- on forme une autre partie (40) du dispositif dans le substrat semiconducteur standard ainsi transformé, du côté de la face avant de ce substrat semiconducteur standard.

14. Procédé selon l'une quelconque des revendications 12 et 13, dans lequel on forme en outre des contacts électriques (48, 50) du dispositif sur la couche mince, en laquelle a été transformé le substrat semiconducteur standard, et sur le substrat électriquement conducteur.

15. Procédé selon l'une quelconque des revendications 12 à 14, dans lequel le substrat électriquement conducteur (44) est fait d'un matériau choisi parmi les semiconducteurs fortement dopés et les métaux.

16. Procédé selon la revendication 14, dans lequel le substrat électriquement conducteur est fait d'un matériau choisi parmi les semiconducteurs fortement dopés, le métal ou l'alliage métal/semiconducteur étant choisi de sorte qu'il forme, après un recuit suivant le collage électriquement conducteur, un alliage stable avec le matériau dont est fait le substrat électriquement conducteur et avec le matériau dont est fait le substrat semiconducteur standard.

17. Procédé selon l'une quelconque des revendications 15 et 16 dans lequel le semiconducteur fortement dopé est le silicium.

18. Procédé selon la revendication 15, dans lequel l'étape de collage électriquement conducteur est précédée d'une étape de préparation d'au moins l'une des deux faces à assembler par le collage électriquement conducteur afin de favoriser ce collage.

19. Procédé selon l'une quelconque des revendications 17 à 18, dans lequel le collage électriquement conducteur (46) est choisi parmi le collage par brasure, le collage par thermocompression et le collage par adhésion moléculaire.

## Claims

1. Electronic device comprising an active part (38, 40,42), a first thin layer (36) which is made of a semiconductor material and in which this active part is formed, and a substrate (44) made of an electrically conductive material, this device being **characterized in that** it also comprises a carrier recombination zone (46) which is located between the substrate and the first thin layer and which also ensures a resistive electric contact between this substrate and this first thin layer.

2. Device as in claim 1, wherein the carrier recombination zone is a second thin layer (46) which is made of an electrically conductive material and which ensures electrically conductive bonding between the substrate and the first thin layer.

3. Device as in either of claims 1 and 2, wherein the two sides of the first thin layer (36) are treated to form active zones (38,40) of the device.

4. Device as in any of claims 1 to 3, wherein the material in which the carrier recombination zone (46) is made is a metal.

5. Device as in any of claims 1 to 3, wherein the material in which the carrier recombination zone (46) is made is a semiconductor/metal alloy.

6. Device as in claim 5, wherein the alloy in which the carrier recombination zone (46) is made is chosen so that it is stable with respect to the materials in which the substrate and the first thin layer are respectively made.

7. Device as in any of claims 1 to 6, wherein the material in which the substrate (44) is made is a highly doped semiconductor.

8. Device according to claim 7, wherein the highly doped semiconductor is silicon.

9. Device as in either of claims 7 and 8, wherein the material which the carrier recombination zone (46) is made is a metal and this metal is chosen so that, when fabricating the resistive electric contact, it forms a stable alloy with the highly doped semiconductor in which the substrate is made and with the semiconductor material in which the first thin layer is made.

10. Device as in any of claims 1 to 6, wherein the material in which the substrate (44) is made is a metal.

11. Device as in claim 10, wherein the carrier recombination zone (46) is made in the metal in which the substrate is made and is formed by part of this substrate.

12. Process for fabricating an electronic device, this process being **characterized in that** it comprises the following steps:
part (38, 42) of the device is formed in a standard semiconductor substrate (52), on the front side of this standard semiconductor substrate,
a treatment support (54) is fixed to the front side of the substrate,
- the standard semiconductor substrate is thinned via its rear side, so as to transform it into a thin layer (36),
- another part (40) of the device is formed in the standard semiconductor substrate so transformed, on the rear side of this standard semiconductor substrate,
- on the rear side of this standard semiconductor substrate and/or on a side of an electrically conductive substrate, a thin layer is deposited formed of a metal or of a metal/semiconductor alloy,
- via the thin layer formed of the metal or metal/semiconductor alloy, electrically conductive bonding is carried out between the electrically conductive substrate and the thin layer into which the standard semiconductor substrate was transformed, and
- the treatment support (54) is removed.

13. Process for fabricating an electronic device, this process being **characterized in that** it comprises the following steps:
- part (38, 42) of the device is formed in a standard semiconductor substrate (52), on the rear side of this standard semiconductor substrate,
- on the rear side of this standard semiconductor substrate and/or on a side of an electrically conductive substrate, a thin layer is deposited formed of a metal or a metal/semiconductor alloy,
- electrically conductive bonding is carried out between the electrically conductive substrate and the standard semiconductor substrate, via the thin layer,
- the standard semiconductor substrate is thinned via its front side so as to transform it into a thin layer (36), and
- another part (40) of the device is formed in the standard semiconductor substrate so transformed, on the front side of this standard semiconductor substrate.

14. Process as in either of claims 12 and 13, wherein electric contacts (48, 50) of the device are also formed on the thin layer in which the standard semiconductor substrate was transformed, and on the electrically conductive substrate.

15. Process as in any of claims 12 to 14, wherein the electrically conductive substrate (44) is made of a material chosen from among highly doped semiconductors and metals.

16. Process as in claim 14, wherein the electrically conductive substrate is made of a material chosen from among highly doped semiconductors, the metal or the metal/semiconductor alloy being chosen so that, after annealing subsequent to electrically conductive bonding, it forms a stable alloy with the material in which the electrically conductive substrate is made and with the material in which the standard semiconductor substrate is made.

17. Process as in either of the claims 15 and 16, wherein the highly doped semiconductor is silicon.

18. Process as in claim 15, wherein the electrically conductive bonding step is preceded by a preparative step to prepare at least one of the two sides to be assembled by electrically conductive bonding, so as to promote this bonding.

19. Process as in any of claims 12 to 18, wherein electrically conductive bonding (46) is chosen from among bonding by soldering, bonding by thermal compression and bonding by molecular adhesion.

## Patentansprüche

1. Elektronische Vorrichtung, die einen aktiven Teil (38, 40, 42), eine erste Dünnschicht (36) aus einem Halbleitermaterial, in der dieser aktive Teil ausgebildet ist, und ein Substrat (44) umfasst, das aus einem elektrisch leitfähigen Material ist,
**dadurch gekennzeichnet, dass** sie außerdem eine Trägerrekombinationszone (46) umfasst, die sich zwischen dem Substrat und der ersten Dünnschicht befindet und die auch einen ohmschen elektrischen Kontakt zwischen diesem Substrat und dieser ersten Dünnschicht gewährleistet.

2. Vorrichtung nach Anspruch 1, bei der die Trägerrekombinationszone eine zweite Dünnschicht (46) aus einem elektrisch leitfähigen Material ist, die eine elektrisch leitfähige Klebung bzw. Haftung zwischen dem Substrat und der ersten Dünnschicht gewährleistet.

3. Vorrichtung nach einem der Ansprüche 1 und 2, bei der die beiden Seiten der ersten Dünnschicht (36) bearbeitet werden, um die aktiven Zonen (38, 40) der Vorrichtung zu bilden.

4. Vorrichtung nach einem der Ansprüche 1 bis 3, bei der das Material, aus dem die Trägerrekombinationszone (46) ist, ein Metall ist.

5. Vorrichtung nach einem der Ansprüche 1 bis 3, bei der das Material, aus dem die Trägerrekombinationszone (46) ist, eine Halbleiter/Metall-Legierung ist.

6. Vorrichtung nach Anspruch 5, bei der die Legierung, aus der die Trägerrekombinationszone (46) ist, so gewählt wird, dass sie stabil ist gegenüber den Materialien, aus denen jeweils das Substrat und die erste Dünnschicht sind.

7. Vorrichtung nach einem der Ansprüche 1 bis 6, bei der das Material, aus dem das Substrat (44) ist, ein stark dotierter Halbleiter ist.

8. Vorrichtung nach Anspruch 7, bei der der stark dotierte Halbleiter das Silicium ist.

9. Vorrichtung nach einem der Ansprüche 7 und 8, bei der das Material, aus dem die Trägerrekombinationszone (46) ist, ein Metall ist und dieses Metall so gewählt wird, dass es bei der Realisierung des ohmschen elektrischen Kontakts eine stabile Legierung bildet mit dem stark dotierten Halbleiter, aus dem das Substrat ist, und mit dem Halbleitermaterial, aus dem die erste Dünnschicht ist.

10. Vorrichtung nach einem der Ansprüche 1 bis 6, bei der das Material, aus dem das Substrat ist, ein Metall ist.

11. Vorrichtung nach Anspruch 10, bei der die Trägerrekombinationszone (46) aus demselben Material wie das Substrat ist und durch einen Teil dieses Substrats gebildet wird.

12. Verfahren zur Herstellung einer elektronischen Vorrichtung, wobei dieses Verfahren **dadurch gekennzeichnet ist, dass** es die folgenden Schritte umfasst:
- man bildet in einem Standardhalbleitersubstrat (52) auf der Vorderseite dieses Standardhalbleitersubstrats einen Teil (38, 42) aus,
- man befestigt einen Bearbeitungsträger (54) an der Vorderseite des Substrats,
- man macht das Standardhalbleitersubstrat von seiner Rückseite her dünner, um es in eine Dünnschicht (36) zu verwandeln,
- man bildet in dem auf diese Weise verwandelten Standardhalbleitersubstrat auf der Rückseite dieses Standardhalbleitersubstrats einen anderen Teil (40) aus,
- man scheidet auf der Rückseite dieses Standardhalbleitersubstrats und/oder auf einer Seite eines elektrisch leitfähigen Substrats eine Dünnschicht ab, gebildet durch ein Metall oder eine Metall/Halbleiter-Legierung,
- man realisiert mittels der aus Metall oder Metall/Halbleiter-Legierung gebildeten Dünnschicht eine elektrisch leitfähige Klebung bzw. Haftung zwischen dem elektrisch leitfähigen Substrat und der Dünnschicht, in die man das Standardhalbleitersubstrat verwandelt hat, und
- man entfernt den Bearbeitungsträger (54).

13. Verfahren zur Herstellung einer elektronischen Vorrichtung, wobei dieses Verfahren **dadurch gekennzeichnet ist, dass** es die folgenden Schritte umfasst:
- man bildet in einem Standardhalbleitersubstrat (52) auf der Rückseite dieses Standardhalbleitersubstrats einen Teil (38, 42) aus,
- man scheidet auf der Rückseite dieses Standardhalbleitersubstrats und/oder auf einer Seite eines elektrisch leitfähigen Substrats eine Dünnschicht ab, gebildet durch ein Metall oder eine Metall/Halbleiter-Legierung,
- man realisiert mittels der aus Metall oder Metall/Halbleiter-Legierung gebildeten Dünnschicht eine elektrisch leitfähige Klebung bzw. Haftung zwischen dem elektrisch leitfähigen Substrat und dem Standardhalbleitersubstrat,
- man macht das Standardhalbleitersubstrat von seiner Vorderseite her dünner, um es in eine Dünnschicht (36) zu verwandeln, und
- man bildet in dem auf diese Weise verwandelten Standardhalbleitersubstrat auf der Vorderseite dieses Standardhalbleitersubstrats einen anderen Teil (40) aus.

14. Verfahren nach einem der Ansprüche 12 und 13, bei dem man außerdem auf der Dünnschicht, in die das Standardhalbleitersubstrat verwandelt worden ist, und auf dem elektrisch leitfähigen Substrat elektrische Kontakte (48, 50) der Vorrichtung ausbildet.

15. Verfahren nach einem der Ansprüche 12 bis 14, bei dem das elektrisch leitfähige Substrat (44) aus einem Material ist, das ausgewählt wird unter den stark dotierten Halbleitern und den Metallen.

16. Verfahren nach Anspruch 15, bei dem das elektrisch leitfähige Substrat aus einem Material ist, das ausgewählt wird unter den stark dotierten Halbleitern, und das Metall oder die Metall/Halbleiter-Legierung so ausgewählt wird, dass es bzw. sie nach einem auf die elektrisch leitfähige Klebung folgenden Tempern eine stabile Legierung bildet mit dem Material, aus dem das elektrisch leitfähige Substrat gemacht ist, und mit dem Material, aus dem das Standardhalbleitersubstrat gemacht ist.

17. Verfahren nach einem der Ansprüche 15 und 16, bei dem der stark dotierte Halbleiter das Silicium ist.

18. Verfahren nach Anspruch 15, bei welchem dem Schritt der elektrisch leitfähigen Klebung ein Schritt zur Vorbereitung wenigstens einer der beiden durch die elektrisch leitfähige Klebung zusammenzufügenden Seiten bzw. Flächen vorausgeht, um diese Klebung zu begünstigen.

19. Verfahren nach einem der Ansprüche 12 bis 18, bei dem die elektrisch leitfähige Klebung bzw. Haftung (46) ausgewählt wird unter Lötung, Thermokompression und Molekularadhäsion.
